# FASCICULE DE BREVET EUROPEEN

(11) **EP 3 115 129 B1**
(45) Date de publication et mention de la délivrance du brevet: **21.08.2019**
(21) Numéro de dépôt: 16178350.1
(22) Date de dépôt: 07.07.2016
(51) Int. Cl.: B22F 1/00, B22F 3/10, B22F 7/06

(54) **ENSEMBLE COMPORTANT UN ELEMENT SUSCEPTIBLE DE TRANSMETTRE DE LA CHALEUR, UN FILM DE POLYMERE BON CONDUCTEUR THERMIQUE ET ISOLANT ELECTRIQUE, UN JOINT FRITTE ET UN RADIATEUR ET PROCEDE DE FABRICATION**
ANORDNUNG, DIE EIN FÜR DIE WÄRMEÜBERTRAGUNG GEEIGNETES ELEMENT, EINEN GUT WÄRMELEITENDEN UND ELEKTRISCH ISOLIERENDEN POLYMERFILM, EINE SINTERDICHTUNG UND EINEN HEIZKÖRPER UMFASST, SOWIE ENTSPRECHENDES HERSTELLUNGSVERFAHREN
ASSEMBLY COMPRISING AN ELEMENT CAPABLE OF TRANSMITTING HEAT, HIGHLY HEAT CONDUCTIVE POLYMER FILM AND ELECTRICAL INSULATOR, SINTERED SEAL AND RADIATOR, AND METHOD OF MANUFACTURING SAME

(30) Priorité: 10.07.2015 FR 1556560
(43) Date de publication de la demande: 11.01.2017
(73) Titulaire: COMMISSARIAT À L'ÉNERGIE ATOMIQUE ET AUX ÉNERGIES ALTERNATIVES, 75015 Paris (FR)
(72) Inventeur: KHAZAKA, Rabih, 38700 LA TRONCHE (FR)
(74) Mandataire: Esselin, Sophie

(56) Documents cités:
- WO-A1-2010/111581
- WO-A1-2015/005373
- US-A- 4 810 563
- US-A1- 2009 162 557
- US-A1- 2012 153 012

## Description

Le domaine de l'invention est celui des substrats métallisés isolés électriquement et à faible résistance thermique intégrés dans des assemblages destinés notamment à des modules de puissance.

Une des applications ciblées de la présente invention concerne les applications forte densité de puissance et haute température (supérieure à 200°C) et permettant de supprimer la céramique isolante et la graisse thermique utilisées classiquement.

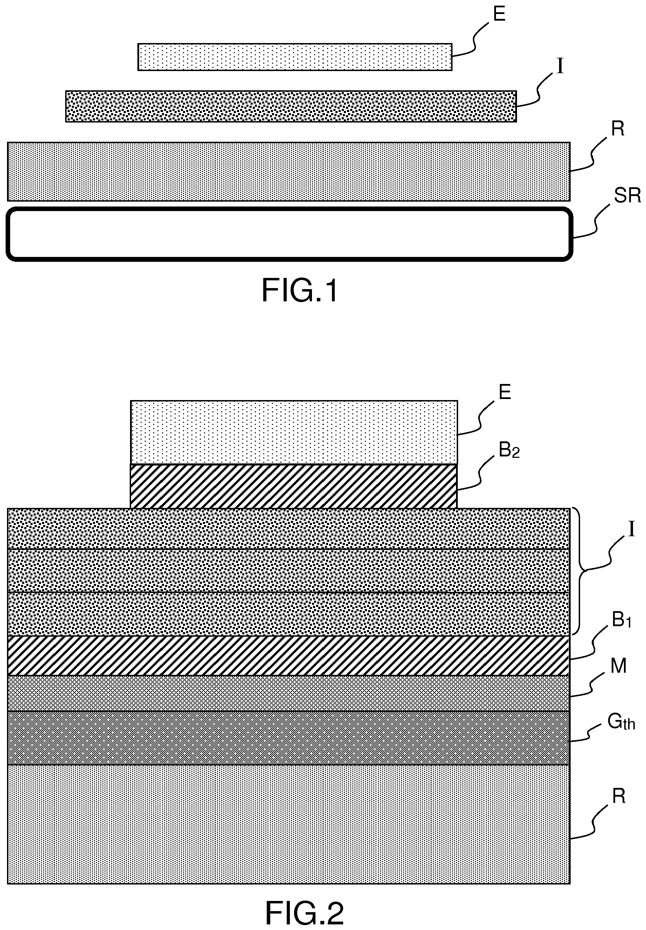

Les modules de puissance comprennent de manière courante comme schématisé en éclaté sur la figure 1, une puce semi-conductrice : élément E susceptible de générer de la chaleur, un isolant électrique I (substrat diélectrique) préservant l'information dans ladite puce semi-conductrice, et un système de refroidissement SR qui évacue la chaleur du système via un drain thermique R, solidaire de l'isolant électrique.

De manière générale, Il est à noter qu'en électronique de puissance, seuls sont actuellement proposés des substrats céramiques reportés sur un drain thermique (pour les modules multipuces devant assurer une isolation entre puces drain thermique).

Le substrat isolant a deux fonctions principales : il peut supporter les pistes conductrices (en cuivre principalement) et assurer également l'isolation électrique entre les puces semi-conductrices et le système de refroidissement.

Un exemple d'empilement souvent employé dans la fabrication des modules de puissance comprend plus précisément les éléments suivants : le composant semi-conducteur (source de chaleur), la brasure pour reporter le composant semi-conducteur sur un substrat, le substrat généralement constitué d'une céramique entre deux plaques métalliques, fabriqué par différentes techniques (« direct bonded copper » : DBC, « active metal braze » : AMB, « direct bonded aluminum » : DBA) et permettant de réaliser les interconnections (semi-conducteurs entre eux et avec l'extérieur) sur les pistes métalliques supérieures et le report sur une semelle par la partie métallique inferieure. Une autre brasure est également prévue pour reporter le substrat sur la semelle généralement en cuivre Cu, qui a pour rôle d'étaler le flux thermique.

L'assemblage est ensuite reporté sur le radiateur à l'aide de graisse thermique.

La figure 2 présente schématiquement un tel ensemble connu et les propriétés thermiques des matériaux utilisés sont données ci-après.

Cet exemple d'ensemble illustré en figure 1 met en évidence :
- un drain thermique principal R couramment dénommé radiateur, pouvant typiquement présenté une conductivité thermique supérieure à 100 W.m⁻¹ K⁻¹ et pouvant être en cuivre ;
- une graisse thermique Gth d'épaisseur 200 µm et de conductivité thermique de l'ordre de 2 W. m⁻¹. K⁻¹ ;
- une semelle en cuivre M reportée, pour étaler la chaleur et constituant un drain thermique secondaire, d'épaisseur 1000 µm ;
- une brasure B1 de 50 µm et de conductivité thermique de l'ordre de 40 W. m⁻¹. K⁻¹ ;
- un substrat isolant I de type DBC « direct bonded copper » constitué d'une plaque céramique en Al2O3 comportant sur ses deux faces des couches de cuivre d'épaisseur égale à 300 µm et de conductivité thermique égale à 400 W. m⁻¹. K⁻¹, la plaque de céramique présentant une épaisseur typiquement de 600 µm et une conductivité thermique égale à 20 W. m⁻¹. K⁻¹ (cas Al2O3);
- une seconde brasure B2 d'épaisseur égale à 50 µm et de conductivité thermique de l'ordre de 40 W. m⁻¹. K⁻¹ ;
- une puce silicium E de conductivité thermique égale à 100 W. m⁻¹. K⁻¹.

Cet empilement présente plusieurs limitations pour les applications dites « hautes températures » (une « haute température » pouvant être due à une température ambiante élevée où à la forte densité de puissance dissipée dans les semi-conducteurs) et notamment les inconvénients suivants :
- une forte résistance thermique initialement due à la céramique, la graisse thermique et les 9 interfaces entre le semi-conducteur, et le fluide de refroidissement qui bloque la dissipation thermique et limite la densité de puissance des semi-conducteurs ;
- une mauvaise stabilité à haute température, limitée par la température de fonctionnement de la graisse thermique et des brasures ;
- une fiabilité thermomécanique limitée due à la fissuration de la céramique (AlN et Al₂O₃), la fissuration dans la brasure et la flèche du substrat due aux contraintes thermomécaniques asymétriques imposées par la structure (des pistes métalliques supérieures gravées et inférieures pleine plaque) suite à l'essai de cycles thermiques.

Il a déjà été décrit et notamment dans le brevet US 8 257 795, l'utilisation d'une pâte de nanoparticules métalliques pour assurer la connexion thermique, mécanique et électrique du semi-conducteur sur un substrat. Cela revient à remplacer la brasure entre la puce et le métal du substrat par un joint d'argent fritté permettant le fonctionnement à haute température et l'amélioration des propriétés électriques et thermiques du joint. Néanmoins, l'invention décrite dans ce brevet ne permet pas de supprimer les problèmes générés par la présence de la céramique et la présence de la graisse thermique.

Il a également été décrit dans la publication: Nanotechnology 21 (2010), « Adhésion mechanisms of nanoparticle silver to substrate materials: identification », les mécanismes d'adhésion entre la pâte de nanoparticules d'argent et des substrats métalliques et isolants (céramiques et polymères). Une couche mince de 2 µm est déposée puis frittée sur des films polymères (Téflon® et Kapton®), suivi d'essais de décollage avec un scotch adhésif pour évaluer l'adhésion à l'interface. Les essais se limitent à cette étape, sans arriver à des structures plus développées et concernent des couches très minces non compatibles avec l'électronique de puissance.

Il est également connu et décrit dans l'article paru dans Macromolecular research 17 (2008), « Sintering and consolidation of silver nanoparticles printed on polyimide substrate films », l'impression directe de pâte de nanoparticules d'argent (épaisseur inférieure à 2 µm) réalisée et frittée à différentes températures sur des substrats polyimide pour réaliser des circuits électroniques. Les essais de frittage de pâte d'argent sur du polymère se limitent à ce niveau-là.

Il a déjà été décrit dans la demande de brevet US 4 810 563, un ensemble comprenant un composant semi-conducteur susceptible de transmettre de la chaleur, un substrat comportant des films de polymère bons conducteurs thermique et isolants électrique; où l'assemblage comportant un joint métallique en contact avec ledit film de polymère.

Il a déjà été décrit dans la demande de brevet US 2009/162557, un procédé de fabrication d'un ensemble comportant:- un dispositif de silicium susceptible de transmettre de la chaleur; ledit procédé comportant la réalisation d'un joint fritté métallique entre ledit élément susceptible de transmettre de la chaleur et ledit substrat.

Dans ce contexte, le Demandeur a cherché une solution intégrant un substrat permettant de pallier aux inconvénients précités et notamment ceux dus à la nécessité d'utiliser une graisse thermique lors de l'assemblage d'un composant semi-conducteur de puissance, d'un substrat céramique type « DBC » et d'un drain thermique principal, permettant d'évacuer la chaleur générée en cours de fonctionnement. La solution de la présente invention concerne ainsi des assemblages utilisant des isolants organiques faciles de report sur des drains thermiques et adaptés aux applications modules de puissance, grâce notamment à la présence de joint fritté et d'au moins un film de polymère bon conducteur thermique et isolant électrique.

De manière plus générale, la présente invention peut adresser également la problématique des ensembles comprenant des structures multi-couches métalliques épaisses que l'on veut joindre ensemble et susceptibles de véhiculer du courant et de la chaleur tout en assurant une isolation électrique entre des pistes métalliques et pour lesquels la solution proposée dans la présente invention inclut la présence de joint(s) fritté(s) associé(s) à un ou plusieurs films de polymère bon conducteur thermique et isolant électrique.

Plus précisément la présente invention a pour objet un ensemble comprenant :
- au moins un élément susceptible de transmettre de la chaleur ;
- au moins un substrat isolant électrique comportant au moins un film de polymère bon conducteur thermique et isolant électrique ;
- au moins un joint fritté métallique en contact avec ledit film de polymère ;
- un radiateur principal ;
ledit radiateur principal étant en contact direct ou en contact via un joint fritté, avec ledit substrat.

Selon des variantes de l'invention, l'élément susceptible de transmettre de la chaleur est un composant semi-conducteur.

Selon des variantes de l'invention, l'élément susceptible de transmettre de la chaleur est une puce en silicium.

Selon des variantes de l'invention, l'élément susceptible de transmettre de la chaleur est une structure épaisse métallique pouvant présenter une épaisseur typiquement supérieure à environ quelques dizaines de microns.

Selon des variantes de l'invention, ledit joint fritté est discontinu.

Selon des variantes de l'invention, l'ensemble comprend des pistes métalliques constituées au moins en partie par ledit joint fritté discontinu, l'élément susceptible de transmettre la chaleur étant relié audit joint fritté discontinu par l'intermédiaire d'un autre joint fritté métallique.

Selon des variantes de l'invention, l'ensemble comporte un élément intermédiaire à forte conductivité thermique pouvant être métallique en contact avec ledit joint, permettant une répartition latérale du flux thermique pouvant être généré, dans un plan parallèle au plan dudit substrat.

Selon des variantes de l'invention, l'élément intermédiaire à forte conductivité thermique est inséré entre un premier joint et un second joint, ledit second joint étant en contact avec ledit élément susceptible de dégager de la chaleur.

Selon des variantes de l'invention, ledit élément intermédiaire comporte un ensemble de pistes métalliques.

Selon des variantes de l'invention, ledit élément intermédiaire est un élément appartenant à un cadre de connexion.

Selon des variantes de l'invention, le premier et/ou le second joint sont des joints métalliques pouvant être en argent.

Selon des variantes de l'invention, le polymère conducteur thermique et isolant électrique est un polyimide ou un polyamide ou un polyamide-imide.

Selon des variantes de l'invention, le polymère conducteur thermique et isolant électrique est chargé avec des particules pouvant être des particules diélectriques (en alumine ou nitrure de bore) ou des particules métalliques.

Selon des variantes de l'invention, l'ensemble comporte au moins un film de polymère conducteur thermique et isolant électrique à la surface dudit radiateur ou à la surface dudit joint fritté.

Selon des variantes de l'invention, l'élément susceptible de transmettre de la chaleur est une structure épaisse métallique, le radiateur étant une structure épaisse métallique, lesdites structures métalliques pouvant comprendre des épaisseurs typiquement supérieures à environ quelques dizaines de microns.

Selon des variantes de l'invention, l'ensemble comprend un empilement comportant :
- au moins une première structure épaisse métallique ;
- au moins un premier joint fritté ;
- au moins un film de polymère ;
- au moins un second joint fritté ;
- au moins une seconde structure épaisse métallique.

Selon des variantes de l'invention, le radiateur est une structure épaisse pouvant être en cuivre ou en aluminium ou en AlSiC, l'épaisseur de ladite structure épaisse pouvant typiquement être supérieure à environ 500 µm.

L'invention a aussi pour objet un procédé de fabrication d'un ensemble comportant :
- un élément susceptible de transmettre de la chaleur ;
- un substrat isolant électrique comportant au moins un film de polymère bon conducteur thermique et isolant électrique ;
- au moins un radiateur principal,
- ledit radiateur principal étant en contact direct ou en contact via un joint fritté, avec ledit substrat,
ledit procédé comportant la réalisation d'un joint fritté métallique en contact avec ledit film de polymère bon conducteur thermique et isolant électrique.

Selon des variantes de l'invention, le procédé comprend la réalisation d'un joint fritté métallique entre un film sec de polymère conducteur thermique et isolant électrique et ledit radiateur.

Selon des variantes de l'invention, le procédé comporte le dépôt d'une résine de polymère conducteur thermique et isolant électrique à la surface dudit radiateur suivi d'une étape de séchage de ladite résine.

Selon des variantes de l'invention, le procédé comprend les étapes suivantes :
- le dépôt d'une moins une première pâte ou d'un premier film sec de micro ou nanoparticules métalliques, destiné(e) à former un joint métallique à la surface dudit film de polymère bon conducteur thermique et isolant électrique ;
- le dépôt dudit élément susceptible de transmettre de la chaleur au dessus de ladite première pâte ou dudit premier film sec de micro ou nanoparticules métalliques ;
- une opération de frittage de manière à former un premier joint fritté assurant la liaison entre ledit élément susceptible de transmettre de la chaleur et ledit substrat.

Selon des variantes de l'invention, le dépôt de la première pâte est effectué par sérigraphie.

Selon des variantes de l'invention, le procédé comprend :
- l'introduction d'un élément intermédiaire à forte conductivité thermique à la surface de ladite première pâte ou dudit premier film ;
- la réalisation d'un second joint entre ledit élément intermédiaire et ledit élément susceptible de dégager de la chaleur.

Selon des variantes de l'invention, le procédé comprend :
- le dépôt d'une seconde pâte ou d'un second film sec de micro ou nanoparticules métalliques à la surface dudit élément intermédiaire, destiné(e) à former un second joint ;
- le dépôt dudit élément susceptible de dégager de la chaleur à la surface de ladite seconde pâte ou dudit film sec ;
- une ou plusieurs opération(s) de frittage de manière à former un premier joint fritté et un second joint fritté assurant la liaison entre ledit élément susceptible de dégager de la chaleur et ledit substrat.

Selon des variantes de l'invention, l'introduction d'un élément intermédiaire à forte conductivité thermique à la surface de ladite première pâte ou dudit premier film sec de micro ou nanoparticules métalliques comprend l'attache de pistes métalliques audit film de polymère conducteur thermique et isolant électrique, au dessus de ladite première pâte ou dudit premier film sec de micro ou nanoparticules métalliques.

Selon des variantes de l'invention, le procédé comprend le report d'un cadre de connexion comportant ledit élément intermédiaire à forte conductivité thermique à la surface de ladite première pâte ou dudit premier film sec de micro ou nanoparticules métalliques permettant l'introduction dudit élément intermédiaire à forte conductivité thermique.

Selon des variantes de l'invention, le procédé comprend une étape de séchage de ladite première pâte ou de ladite première pâte et de ladite seconde pâte avant l'opération de frittage.

Selon des variantes de l'invention, le procédé comporte la réalisation de pistes métalliques constituées au moins en partie par un joint fritté métallique, l'élément susceptible de transmettre la chaleur étant relié audit joint fritté métallique discontinu par l'intermédiaire d'un autre joint fritté métallique.

L'invention sera mieux comprise et d'autres avantages apparaîtront à la lecture de la description qui va suivre donnée à titre non limitatif et grâce aux figures annexées parmi lesquelles :
- la figure 1 schématise un module de puissance selon l'art connu ;
- la figure 2 illustre un ensemble comprenant un assemblage classique d'un composant semiconducteur sur un substrat isolant et un radiateur selon l'art connu ;
- la figure 3 illustre un premier exemple d'un ensemble selon l'invention;
- la figure 4 illustre un second exemple d'un ensemble selon l'invention ;
- les figures 5a à 5d illustrent les principales étapes d'un exemple de procédé de fabrication d'un ensemble selon l'invention ;
- les figures 6a et 6b illustrent des étapes d'un second exemple de procédé de fabrication d'un ensemble selon l'invention ;
- la figure 7 illustre une photographie microscopique d'un ensemble comprenant un ensemble selon l'invention ;
- les figures 8a et 8b illustrent deux exemples de quatrième variante d'un ensemble selon l'invention comprenant des structures épaisses métalliques, des joints frittés métalliques et des films de polymère.

De manière générale, l'ensemble de la présente invention comporte un élément susceptible de dégager de la chaleur, et pouvant notamment être une puce semi-conductrice utilisée pour des applications en électronique de puissance, un joint fritté et un substrat organique comportant au moins un film de polymère bon conducteur thermique et isolant électrique et un radiateur permettant d'évacuer au mieux la chaleur générée en cours de fonctionnement.

Le film de polymère peut être obtenu à partir d'une résine. Il est également possible d'utiliser un film polymérisé permettant la réalisation de connectique face inférieure de la même façon que celle sur la face supérieure (par des opérations de frittage comme il sera décrit plus en détails ci-après).

Le radiateur peut être un radiateur en cuivre comme décrit ci-après, mais peut également être constitué d'alliages ou de colaminés.

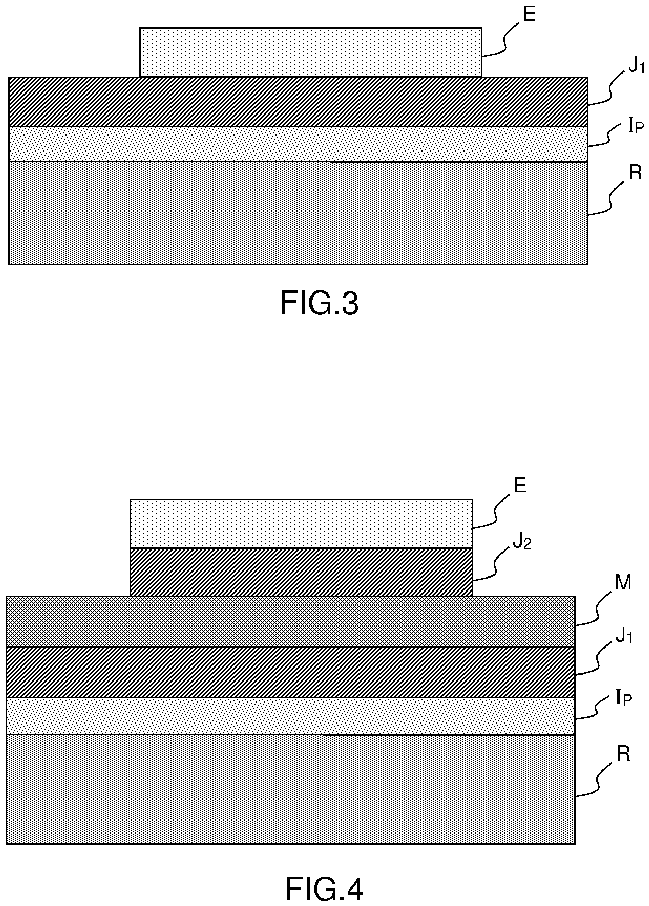

Selon une première variante de l'invention, illustrée en figure 3, l'ensemble peut comporter :
- un radiateur R pouvant être une structure massive bonne conductrice de la chaleur ;
- un film de polymère conducteur thermique et isolant électrique I_{P} ;
- un joint fritté J1 ;
- un élément E susceptible de dégager de la chaleur, typiquement il peut s'agir d'un composant semi-conducteur tel qu'une puce silicium en contact avec le joint J1 et pouvant présenter une conductivité thermique égale à 100 W. m⁻¹. K⁻¹.

Typiquement, le polymère peut être un polyimide avantageusement chargé de particules d'épaisseur 20 µm et de conductivité thermique égale à 1 W. m⁻¹. K⁻¹. Le polyimide chargé peut être en effet utilisé comme isolant pour ses bonnes propriétés diélectriques, sa bonne stabilité thermique et sa conductivité thermique cinq fois supérieure à celle d'un polyimide sans charges. Il est à noter que d'autres polymères peuvent remplacer le polyimide (par exemple le polyamide, polyamide-imide...).

La technique de dépôt utilisée peut être la sérigraphie en raison de sa simplicité et le bon contrôle de l'épaisseur de l'isolant. Néanmoins, d'autres techniques de dépôt de polymère comme le dépôt à la tournette, en phase vapeur, par jet d'encre, l'électrodéposition..., peuvent aussi être utilisées. L'adhésion du polyimide sur le support assurant une fonction de drain thermique peut être améliorée en utilisant des promoteurs d'adhésion ou en réalisant des traitements de surface spécifiques (par exemple par plasma Argon) sur ledit drain thermique avant le dépôt de la résine polyimide.

Typiquement, le joint J1 peut être en argent, d'épaisseur de 20 µm et de conductivité thermique égale à 200 W. m⁻¹. K⁻¹.

On peut avantageusement réaliser un joint fritté à partir du dépôt d'une pâte suivie d'une opération de frittage. Plus précisément, pour ce faire, une pâte de nanoparticules peut être employée, suivie d'une opération de séchage. Il est également possible d'utiliser un film sec de nanoparticules d'argent permettant de supprimer l'étape de séchage de la pâte.

En comparaison avec une brasure classique ou à une colle conductrice, le frittage de nanoparticules d'argent présente plusieurs avantages :
- une meilleure conductivité thermique (plus que 4 fois supérieures à des brasures classiques) ;
- une température de procédé inférieure à 300 °C et une température de fonctionnement supérieure à 300 °C (dans le cas de la brasure, la température du procédé est supérieure à la température de fonctionnement).

De plus, le joint fritté poreux permet de mieux encaisser les contraintes mécaniques induites par la différence de coefficient de dilatation thermique CTE entre le polymère et le métal lors des cycles thermiques.

La nouvelle structure permet ainsi de franchir les limites thermiques des brasures et de la graisse thermique ainsi que les limites thermomécaniques des substrats céramiques et des joints brasés sur des grandes surfaces.

Dans cette première variante de l'invention, le nombre d'interfaces thermiques est fortement limité et est égal à 4. Le circuit électrique est assuré par la pâte de nanoparticule frittée et déposée par sérigraphie. Néanmoins, malgré la réduction de la résistance thermique en 1D, cette structure ne permet pas l'étalement du flux de chaleur et limite aussi les courants dans les pistes frittées (vu la faible épaisseur du joint).

Selon une seconde variante de l'invention l'ensemble peut comporter en outre un élément intermédiaire à forte conductivité thermique, pouvant être considéré comme un drain thermique secondaire et pouvant être métallique en contact avec ledit premier joint fritté, permettant une répartition latérale du flux thermique pouvant être généré, dans un plan parallèle au plan dudit substrat.

Cet élément intermédiaire peut typiquement être constitué par un ensemble de pistes métalliques reportées et collées à la surface dudit premier joint.

Il peut aussi être constitué par une partie d'un cadre de connexion, couramment désigné par le terme « lead frame».

Une telle configuration est illustrée en figure 4 et comporte :
- un radiateur R ;
- un film de polymère conducteur thermique et isolant électrique I_{P} ;
- un premier joint J1 ;
- un élément intermédiaire M à forte conductivité thermique, ou drain thermique secondaire pouvant être métallique en contact avec ledit premier joint fritté, permettant une répartition latérale du flux thermique pouvant être généré, dans un plan parallèle au plan dudit substrat ;
- un second joint J2 pouvant être identique au premier joint J1 ;
- un élément E susceptible de dégager de la chaleur, typiquement il peut s'agir d'un composant semi-conducteur (ayant une finition métallique de préférence Ag ou Au) tel qu'une puce silicium en contact avec le joint J2 et pouvant par exemple présenter une conductivité thermique égale à 100 W. m⁻¹. K⁻¹.

Les mêmes matériaux et techniques que ceux de la première variante peuvent être employés dans cette seconde variante.

On peut également utiliser des promoteurs d'adhésion ou réaliser des traitements de surface spécifiques (par exemple par plasma Argon) sur le polymère avant le dépôt de la pâte ou du film destiné à réaliser le joint J1, pour en améliorer l'adhésion.

Le métal des pistes peut être le cuivre, choisi pour ces bonnes conductivités thermiques et électriques. D'autres métaux, alliages ou colaminés peuvent aussi être utilisés. Les pistes peuvent avoir des épaisseurs égales ou différentes et peuvent être attachées au polymère, via le joint J1, soit individuellement, soit sous forme de « lead frame » et découpées après. Les dimensions des pistes métalliques doivent être adaptées au courant visé et doivent permettre un étalement du flux thermique.

Le composant semi-conducteur peut être reporté et assemblé grâce à la réalisation du second joint J2. Ce joint J2 peut être réalisé par frittage de nanoparticules, frittage de microparticules, brasage, diffusion sous phase liquide ou tout autre technique de report. Le frittage d'argent reste une technique préférentielle pour ses bonnes propriétés déjà évoquées.

Selon cette variante, les interfaces thermiques de l'empilement sont réduites à 6 (et non plus 4 comme dans la première variante) et tous les matériaux de l'assemblage sont compatibles avec des températures allant jusqu'à 300 °C. Plusieurs épaisseurs d'isolant et de métal peuvent être réalisées dans un même module.

Il est à noter que des simulations thermiques montrent une diminution de la résistance thermique de 55% (empilement de la figure 4) et de 20 % (empilement de la figure 3) par rapport à la structure classique présentée dans la figure 2. Dans le cas de l'empilement de la figure 4, la résistance thermique reste meilleure que celle de la structure classique même si l'épaisseur du polyimide chargé peut passer à 40 µm. Cette augmentation de l'épaisseur d'isolation peut être nécessaire pour les applications sous haute tension (> 2500V).

### Exemple de procédé de fabrication d'un ensemble selon la seconde variante de l'invention

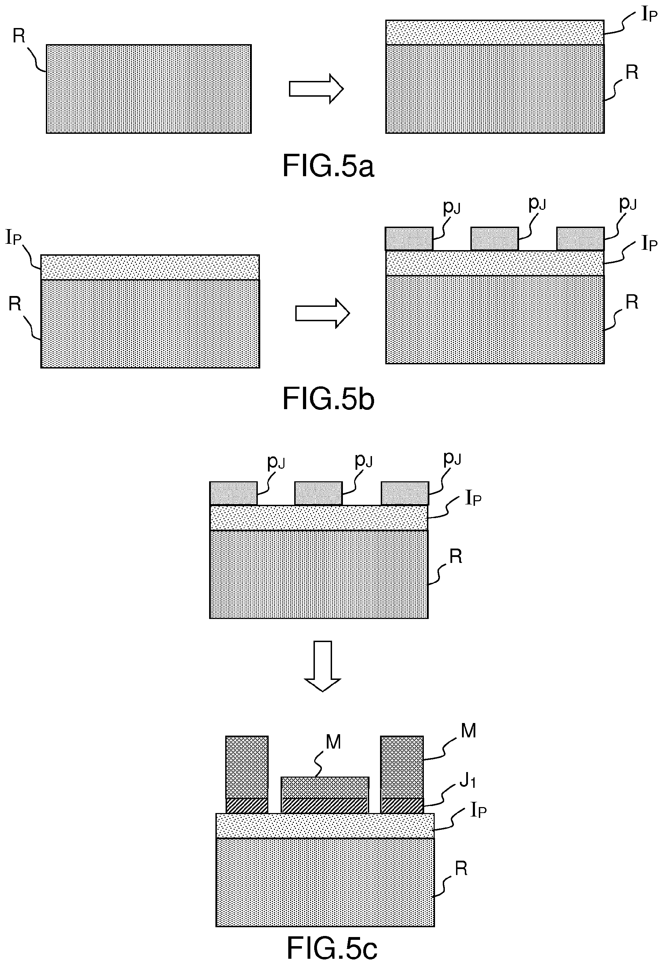

Les étapes de fabrication d'un exemple d'ensemble de l'invention sont présentées sur les figures 5a à 5d.

### Etape 1, illustrée en figure 5a :

Une couche de résine polyimide I_{P} correspondant au film de polymère est déposée par sérigraphie sur le dissipateur thermique principal R, permettant de remplir tous les défauts de non-planéité et de rugosité du radiateur et avoir une surface plane.

La résine pouvant être en polyimide peut avantageusement comprendre des particules pour améliorer sa conductivité thermique (1Wm^{- 1}K⁻¹). L'épaisseur du polyimide peut être contrôlée par le stencil de sérigraphie (50 µm par exemple) et est choisie en fonction de la tension à tenir.

Il est à noter que différentes épaisseurs de polyimide peuvent être réalisées sur le même substrat. Le recuit de la résine se fait ensuite dans un four à 280 °C pour une durée d'une heure. Une épaisseur de 20 µm après recuit est obtenue et permet de tenir 2500 V à 300 °C.

La conductivité à 300 °C est de 10⁻¹¹ (ohm.cm)⁻¹ et la permittivité est de 2.8 à 1 kHz. Cette couche de polyimide permet ainsi d'isoler les tensions des composants électroniques du radiateur.

### Etape 2, illustrée en figure 5b :

Une couche de 70 µm de pâte d'argent p_{J} est ensuite déposée sur le polyimide I_{P} en reproduisant le design des pistes conductrices voulu (seul un élément de pâte est représenté).

Une étape de séchage permettant l'évaporation du solvant de la pâte est réalisée à 130 °C pour 30 minutes.

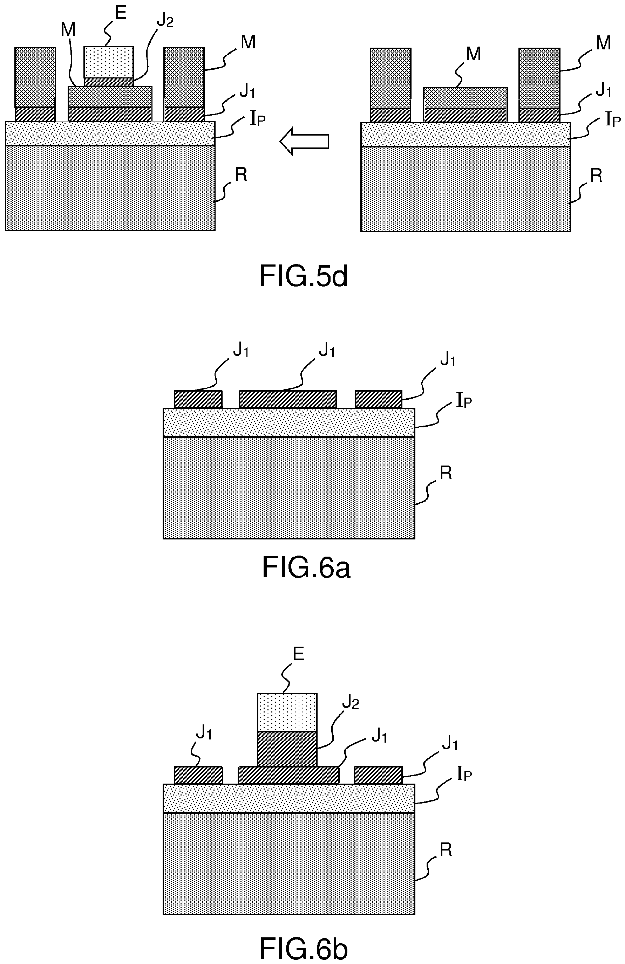

### Etape 3, illustrée en figure 5 c :

Les pistes métalliques M sont ensuite reportées individuellement ou sous forme de réseau de conducteurs couramment dénommé « lead frame » sur les joints J1 (il est à noter que dans le cas de la réalisation de la structure présentée en figure 3, l'élément E semi-conducteur est posé sur la pâte destinée au joint, au lieu d'être posé sur des pistes métalliques). Les conducteurs ou les pistes conductrices peuvent avoir la même épaisseur ou des épaisseurs différentes et être par exemple en cuivre. Une finition Ni/Au est préférable sur le cuivre pour améliorer l'adhésion mécanique du joint fritté avec le métal.

Un cycle de frittage est ensuite réalisé pour attacher les pistes sur le polyimide (dans le cas de la réalisation de la structure présentée dans la figure 3, le cycle de frittage permet d'attacher le semiconducteur).

L'épaisseur du joint fritté J1 ainsi obtenu est de 20 µm environ. L'effet des paramètres de frittage sur l'adhésion des pistes sur le polyimide a été étudié. Pour des pressions de frittage inférieures ou égales à 6MPa l'interface entre le joint d'argent fritté et le polyimide constitue le point faible, avec des rigidités de cisaillement de l'ordre de 100 N pour une surface de 25 mm² et une température de frittage de 280 °C. Cette valeur peut être améliorée à 160 N en augmentant la température de frittage (320 °C). Pour des pressions supérieures à 9MPa l'interface entre le polyimide et le drain thermique devient le point le plus faible avec des forces de cisaillement de l'ordre de 210 N (pour une surface de 25 mm²).

### Etape 4, illustrée en figure 5d :

L'élément E semi-conducteur peut ensuite être reporté sur les pistes M conductrices pouvant être en cuivre par l'intermédiaire d'un second joint J2 obtenu par brasage ou frittage notamment d'argent ou autre technologie de report de puce.

### Exemple de procédé de fabrication d'un ensemble selon une troisième variante de l'invention.

Selon cette variante de l'invention, on réalise des pistes métalliques via un joint fritté métallique discontinu que l'on vient relier via un second joint fritté métallique à l'élément E semi-conducteur.

Plus précisément comme illustré en figure 6a, on réalise à la surface du film Ip en contact avec le radiateur R (selon des techniques précédemment décrites), un premier joint fritté discontinu métallique J1 servant de pistes métalliques. Pour cela on peut utiliser une pièce intermédiaire, non-adhérente avec le joint, permettant l'opération de frittage, afin de réaliser ledit premier joint à partir d'une pâte à fritter.

On réalise ensuite le dépôt d'une seconde pâte à fritter pour réaliser par frittage un second joint fritté métallique J2, permettant de solidariser l'élément E semi-conducteur, comme illustré en figure 6b.

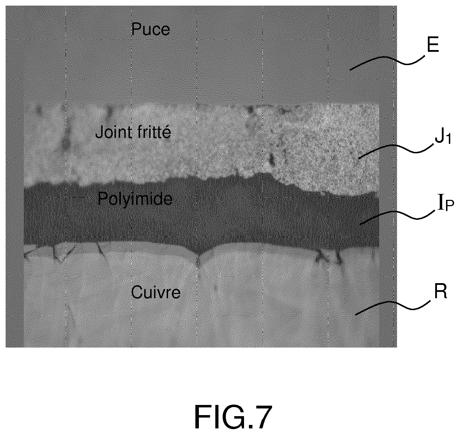

La figure 7 illustre une photographie microscopique d'un ensemble selon la première variante de l'invention décrite précédemment et comprenant l'ensemble : Cuivre (drain thermique principal R) /polyimide (film I_{P}) /frittage Ag (Joint J1)/ semi-conducteur (élément E).

Le polyimide P et le premier joint J1, présentent des épaisseurs d'environ 20 µm.

Selon une quatrième variante de l'invention, l'ensemble peut comprendre comme radiateur ou drain thermique principal, une structure épaisse métallique et comme élément susceptible de transmettre de la chaleur également une structure épaisse métallique.

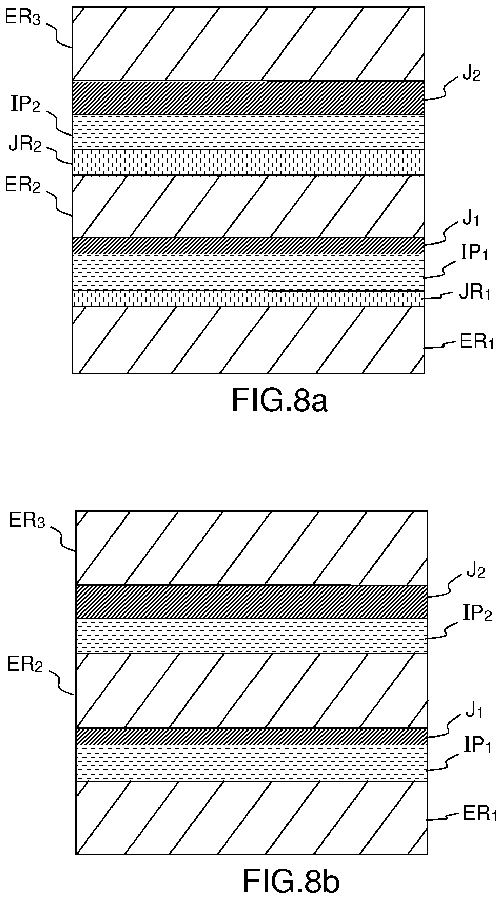

Les structures épaisses sont reliées audit film de polymère par l'intermédiaire de joints frittés métalliques. Il est à noter que dans le cas de l'utilisation de résine de polymère celle-ci peut être directement déposée à la surface d'une structure épaisse métallique, alors que dans le cas de l'utilisation d'un film sec de polymère la liaison est assurée par l'intermédiaire d'un joint fritté métallique. Les figures 8a et 8b illustrent respectivement un exemple d'ensemble utilisant des films à base de résine et un exemple d'ensemble utilisant des films secs.

Dans cette variante, les radiateurs ou drains thermiques et élément susceptibles de transmettre la chaleur sont des structures épaisses métalliques ER₁, ER₂, ER₃ (seules trois structures sont représentées, mais un plus grand nombre pourrait être employé).

Selon l'exemple représenté en figure 8a, les films de polymère I_{P1}, I_{P2} sont des films secs reportés nécessitant l'utilisation de joints frittés J_{R1}, J_{R2} Les films de polymère sont solidarisés eux-mêmes aux structures épaisses supérieures via des joints frittés métalliques J₁,J₂.

Selon l'exemple représenté en figure 8b, les films de polymère I_{P1}, I_{P2} peuvent être obtenus à partir de résine de polymère ne nécessitant pas l'utilisation de joints frittés (absence de joints frittés équivalents aux joints J_{R1}, J_{R2}) Les films de polymère sont solidarisés eux-mêmes aux structures épaisses supérieures via des joints frittés métalliques J₁,J₂.

## Revendications

1. Ensemble comprenant :
- au moins un élément susceptible de transmettre de la chaleur (E) ;
- au moins un substrat isolant électrique comportant au moins un film (I_{P}) de polymère bon conducteur thermique et isolant électrique ;
- au moins un joint fritté métallique (J1) en contact avec ledit film de polymère ;
- un radiateur principal ;
ledit radiateur principal étant en contact direct ou en contact via un joint fritté, avec ledit substrat.

2. Ensemble selon la revendication 1, **caractérisé en ce que** l'élément susceptible de transmettre de la chaleur est un composant semi-conducteur.

3. Ensemble selon la revendication 2, **caractérisé en ce que** l'élément susceptible de transmettre de la chaleur est une puce en silicium.

4. Ensemble selon la revendication 1, **caractérisé en ce que** l'élément susceptible de transmettre de la chaleur est une structure épaisse métallique pouvant présenter une épaisseur typiquement supérieure à environ quelques dizaines de microns.

5. Ensemble selon l'une des revendications 1 à 4, **caractérisé en ce que** ledit joint fritté est discontinu.

6. Ensemble selon la revendication 5, comprenant des pistes métalliques constituées au moins en partie par ledit joint fritté, l'élément susceptible de transmettre la chaleur étant relié audit joint fritté discontinu par l'intermédiaire d'un autre joint fritté.

7. Ensemble selon l'une des revendications 1 à 5, **caractérisé en ce qu'**il comporte un élément intermédiaire à forte conductivité thermique (M), pouvant être métallique en contact avec ledit joint, permettant une répartition latérale du flux thermique pouvant être généré, dans un plan parallèle au plan dudit substrat.

8. Ensemble selon la revendication 7, **caractérisé en ce que** l'élément intermédiaire à forte conductivité thermique est inséré entre un premier joint (J1) et un second joint (J2), ledit second joint étant en contact avec ledit élément susceptible de dégager de la chaleur.

9. Ensemble selon la revendication 7, **caractérisé en ce que** ledit élément intermédiaire comporte un ensemble de pistes métalliques.

10. Ensemble selon la revendication 7, **caractérisé en ce que** ledit élément intermédiaire est un élément appartenant à un cadre de connexion.

11. Ensemble selon l'une des revendications 1 à 10, **caractérisé en ce que** le premier et/ou le second joint sont des joints métalliques pouvant être en argent.

12. Ensemble selon l'une des revendications 1 à 11, **caractérisé en ce que** le polymère conducteur thermique et isolant électrique est un polyimide ou un polyamide ou un polyamide-imide.

13. Ensemble selon l'une des revendications 1 à 12, **caractérisé en ce que** le polymère conducteur thermique et isolant électrique est chargé avec des particules pouvant être des particules diélectriques (en alumine ou nitrure de bore) ou des particules métalliques.

14. Ensemble selon l'une des revendications 1 à 13, **caractérisé en ce qu'**il comporte au moins un film de polymère conducteur thermique et isolant électrique à la surface dudit radiateur ou à la surface dudit joint fritté.

15. Ensemble selon l'une des revendications 1 à 14, **caractérisé en ce que** l'élément susceptible de transmettre de la chaleur est une structure épaisse métallique, le radiateur étant une structure épaisse métallique, lesdites structures métalliques pouvant comprendre des épaisseurs typiquement supérieures à environ quelques dizaines de microns.

16. Ensemble selon la revendication 15, **caractérisé en ce qu'**il comprend un empilement comportant :
- au moins une première structure épaisse métallique ;
- au moins un premier joint fritté ;
- au moins un film de polymère ;
- au moins un second joint fritté ;
- au moins une seconde structure épaisse métallique.

17. Ensemble selon l'une des revendications 1 à 16, **caractérisé en ce que** le radiateur est une structure épaisse pouvant être en cuivre ou en aluminium ou en AlSiC, l'épaisseur de ladite structure épaisse pouvant typiquement être supérieure à environ 500 µm.

18. Procédé de fabrication d'un ensemble comportant :
- un élément susceptible de transmettre de la chaleur ;
- un substrat isolant électrique comportant au moins un film de polymère bon conducteur thermique et isolant électrique ;
- au moins un radiateur principal,
- ledit radiateur principal étant en contact direct ou en contact via un joint fritté, avec ledit substrat,
ledit procédé comportant la réalisation d'un joint fritté métallique en contact avec ledit film de polymère bon conducteur thermique et isolant électrique.

19. Procédé de fabrication selon la revendication 18, comprenant la réalisation dudit joint fritté métallique entre un film sec de polymère conducteur thermique et isolant électrique et ledit radiateur.

20. Procédé de fabrication selon la revendication 18 comportant le dépôt d'une résine de polymère conducteur thermique et isolant électrique à la surface dudit radiateur suivi d'une étape de séchage de ladite résine.

21. Procédé de fabrication selon l'une des revendications 18 à 20, comprenant les étapes suivantes :
- le dépôt d'une moins une première pâte ou d'un premier film sec de micro ou nanoparticules métalliques, destiné(e) à former un joint métallique à la surface dudit film de polymère bon conducteur thermique et isolant électrique ;
- le dépôt dudit élément susceptible de transmettre de la chaleur au dessus de ladite première pâte ou dudit premier film sec de micro ou nanoparticules métalliques ;
- une opération de frittage de manière à former un premier joint fritté assurant la liaison entre ledit élément susceptible de transmettre de la chaleur et ledit substrat.

22. Procédé de fabrication d'un ensemble selon la revendication 21, **caractérisé en ce que** le dépôt de la première pâte est effectué par sérigraphie.

23. Procédé de fabrication d'un ensemble selon l'une des revendications 20 à 22, **caractérisé en ce qu'**il comprend :
- l'introduction d'un élément intermédiaire à forte conductivité thermique à la surface de ladite première pâte ou dudit premier film ;
- la réalisation d'un second joint entre ledit élément intermédiaire et ledit élément susceptible de dégager de la chaleur.

24. Procédé de fabrication d'un ensemble selon la revendication 23, **caractérisé en ce qu'**il comprend :
- le dépôt d'une seconde pâte ou d'un second film sec de micro ou nanoparticules métalliques à la surface dudit élément intermédiaire, destiné(e) à former un second joint ;
- le dépôt dudit élément susceptible de dégager de la chaleur à la surface de ladite seconde pâte ou dudit film sec ;
- une ou plusieurs opération(s) de frittage de manière à former un premier joint fritté et un second joint fritté assurant la liaison entre ledit élément susceptible de dégager de la chaleur et ledit substrat.

25. Procédé de fabrication d'un ensemble selon l'une des revendications 18 ou 24, **caractérisé en ce que** l'introduction d'un élément intermédiaire à forte conductivité thermique à la surface de ladite première pâte ou dudit premier film sec de micro ou nanoparticules métalliques comprend l'attache de pistes métalliques audit film de polymère conducteur thermique et isolant électrique, au dessus de ladite première pâte ou dudit premier film sec de micro ou nanoparticules métalliques.

26. Procédé de fabrication d'un ensemble selon l'une des revendication 18 ou 25, **caractérisé en ce qu'**il comprend le report d'un cadre de connexion comportant ledit élément intermédiaire à forte conductivité thermique à la surface de ladite première pâte ou dudit premier film sec de micro ou nanoparticules métalliques permettant l'introduction dudit élément intermédiaire à forte conductivité thermique.

27. Procédé de fabrication d'un ensemble selon l'une des revendications 18 à 26, **caractérisé en ce qu'**il comprend une étape de séchage de ladite première pâte ou de ladite première pâte et de ladite seconde pâte avant l'opération de frittage.

28. Procédé de fabrication selon l'une des revendications 18 à 22, comportant la réalisation de pistes métalliques constituées au moins en partie par un joint fritté, l'élément susceptible de transmettre la chaleur étant relié audit joint fritté discontinu par l'intermédiaire d'un autre joint fritté.

## Patentansprüche

1. Anordnung, die Folgendes umfasst:
- wenigstens ein Element, das fähig ist, Wärme (E) zu übertragen;
- wenigstens ein elektrisch isolierendes Substrat, das wenigstens einen gut wärmeleitenden und elektrisch isolierenden Polymerfilm (Iₚ) umfasst;
- wenigstens eine metallische gesinterte Dichtung (J1) in Kontakt mit dem Polymerfilm;
- einen Hauptradiator;
wobei der Hauptradiator in direktem Kontakt oder über eine gesinterte Dichtung in Kontakt mit dem Substrat ist.

2. Anordnung nach Anspruch 1, **dadurch gekennzeichnet, dass** das zum Übertragen von Wärme fähige Element ein Halbleiterbauelement ist.

3. Anordnung nach Anspruch 2, **dadurch gekennzeichnet, dass** das zum Übertragen von Wärme fähige Element ein Siliciumchip ist.

4. Anordnung nach Anspruch 1, **dadurch gekennzeichnet, dass** das zum Übertragen von Wärme fähige Element eine dicke metallische Struktur ist, die eine Dicke aufweisen kann, die typischerweise mehr als etwa mehrere Dutzend Mikron beträgt.

5. Anordnung nach einem der Ansprüche 1 bis 4, **dadurch gekennzeichnet, dass** die gesinterte Dichtung diskontinuierlich ist.

6. Anordnung nach Anspruch 5, die metallische Streifen umfasst, die wenigstens teilweise von der gesinterten Dichtung gebildet werden, wobei das zum Übertragen von Wärme fähige Element mit der diskontinuierlichen gesinterten Dichtung mittels einer anderen gesinterten Dichtung verbunden ist.

7. Anordnung nach einem der Ansprüche 1 bis 5, **dadurch gekennzeichnet, dass** sie ein Zwischenelement mit hoher Wärmeleitfähigkeit (M) umfasst, das metallisch in Kontakt mit der Dichtung sein kann, so dass eine laterale Verteilung des Wärmeflusses in einer Ebene parallel zur Ebene des Substrats erzeugt werden kann.

8. Anordnung nach Anspruch 7, **dadurch gekennzeichnet, dass** das Zwischenelement mit hoher Wärmeleitfähigkeit zwischen eine erste Dichtung (J1) und eine zweite Dichtung (J2) eingeführt wird, wobei die zweite Dichtung mit dem zum Übertragen von Wärme fähigen Element in Kontakt ist.

9. Anordnung nach Anspruch 7, **dadurch gekennzeichnet, dass** das Zwischenelement eine Anordnung von metallischen Streifen umfasst.

10. Anordnung nach Anspruch 7, **dadurch gekennzeichnet, dass** das Zwischenelement ein Element ist, das zu einem Verbindungsrahmen gehört.

11. Anordnung nach einem der Ansprüche 1 bis 10, **dadurch gekennzeichnet, dass** die erste und/oder die zweite Dichtung metallische Dichtungen sind, die aus Silber sein können.

12. Anordnung nach einem der Ansprüche 1 bis 11, **dadurch gekennzeichnet, dass** das wärmeleitfähige und elektrisch isolierende Polymer ein Polyimid oder ein Polyamid oder ein Polyamidimid ist.

13. Anordnung nach einem der Ansprüche 1 bis 12, **dadurch gekennzeichnet, dass** das wärmeleitfähige und elektrisch isolierende Polymer mit Partikeln beladen ist, die dielektrische Partikel (aus Aluminiumoxid oder Bornitrid) oder metallische Partikel sein können.

14. Anordnung nach einem der Ansprüche 1 bis 13, **dadurch gekennzeichnet, dass** sie wenigstens einen wärmeleitfähigen und elektrisch isolierenden Polymerfilm auf der Oberfläche des Radiators oder auf der Oberfläche der gesinterten Dichtung umfasst.

15. Anordnung nach einem der Ansprüche 1 bis 14, **dadurch gekennzeichnet, dass** das zum Übertragen von Wärme fähige Element eine dicke metallische Struktur ist, wobei der Radiator eine dicke metallische Struktur ist, wobei die metallischen Strukturen Dicken aufweisen können, die typischerweise mehr als etwa mehrere Dutzend Mikron betragen.

16. Anordnung nach Anspruch 15, **dadurch gekennzeichnet, dass** sie einen Stapel umfasst, der Folgendes umfasst:
- wenigstens eine erste dicke metallische Struktur;
- wenigstens eine erste gesinterte Dichtung;
- wenigstens einen Polymerfilm;
- wenigstens eine zweite gesinterte Dichtung;
- wenigstens eine zweite dicke metallische Struktur.

17. Anordnung nach einem der Ansprüche 1 bis 16, **dadurch gekennzeichnet, dass** der Radiator eine dicke Struktur ist, die aus Kupfer oder Aluminium oder aus AlSiC sein kann, wobei die Dicke der dicken Struktur typischerweise mehr als etwa 500 µm betragen kann.

18. Verfahren zur Herstellung einer Anordnung, das Folgendes beinhaltet:
- ein Element, das fähig ist, Wärme zu übertragen;
- ein elektrisch isolierendes Substrat, das wenigstens einen gut wärmeleitfähigen und elektrisch isolierenden Polymerfilm umfasst;
- wenigstens einen Hauptradiator,
- wobei der Hauptradiator in direktem Kontakt oder über eine gesinterte Dichtung in Kontakt mit dem Substrat ist,
wobei das Verfahren die Herstellung einer metallischen gesinterten Dichtung in Kontakt mit dem gut wärmeleitfähigen und elektrisch isolierenden Polymerfilm ist.

19. Herstellungsverfahren nach Anspruch 18, das die Herstellung der metallischen gesinterten Dichtung zwischen einem wärmeleitfähigen und elektrisch isolierenden trockenen Polymerfilm und dem Radiator beinhaltet.

20. Herstellungsverfahren nach Anspruch 18, das das Absetzen eines wärmeleitfähigen und elektrisch isolierenden Polymerharzes auf der Oberfläche des Radiators gefolgt von einem Schritt des Trocknens des Harzes beinhaltet.

21. Herstellungsverfahren nach einem der Ansprüche 18 bis 20, das die folgenden Schritte beinhaltet:
- Absetzen wenigstens einer ersten Paste oder eines ersten trockenen Films aus metallischen Mikro- oder Nanopartikeln, bestimmt zum Bilden einer metallischen Dichtung auf der Oberfläche des gut wärmeleitfähigen und elektrisch isolierenden Polymerfilms;
- Absetzen des Elements, das fähig ist, Wärme über der ersten Paste oder dem ersten trockenen Film aus metallischen Mikro- oder Nanopartikeln zu übertragen;
- einen Vorgang des Sinterns, um eine erste gesinterte Dichtung zu bilden, die die Verbindung zwischen dem zum Übertragen von Wärme fähigen Element und dem Substrat gewährleistet.

22. Verfahren zur Herstellung einer Anordnung nach Anspruch 21, **dadurch gekennzeichnet, dass** das Absetzen der ersten Paste durch Siebdruck erfolgt.

23. Verfahren zur Herstellung einer Anordnung nach einem der Ansprüche 20 bis 22, **dadurch gekennzeichnet, dass** es Folgendes beinhaltet:
- Einführen eines Zwischenelements mit hoher Wärmeleitfähigkeit auf die Oberfläche der ersten Paste oder des ersten Films;
- Erzeugen einer zweiten Dichtung zwischen dem Zwischenelement und dem zum Abgeben von Wärme fähigen Element.

24. Verfahren zur Herstellung einer Anordnung nach Anspruch 23, **dadurch gekennzeichnet, dass** es Folgendes beinhaltet:
- Absetzen einer zweiten Paste oder eines zweiten trockenen Films aus metallischen Mikro- oder Nanopartikeln auf die Oberfläche des Zwischenelements, um eine zweite Dichtung zu bilden;
- Absetzen des Elements, das fähig ist, Wärme auf die Oberfläche der zweiten Paste oder des trockenen Films abzugeben;
- einen oder mehrere Sintervorgänge zum Bilden einer ersten gesinterten Dichtung und einer zweiten gesinterten Dichtung, die die Verbindung zwischen dem zum Abgeben von Wärme fähigen Element und dem Substrat gewährleistet.

25. Verfahren zur Herstellung einer Anordnung nach Anspruch 18 oder 24, **dadurch gekennzeichnet, dass** das Einführen eines Zwischenelements mit hoher Wärmeleitfähigkeit auf die Oberfläche der ersten Paste oder des ersten trockenen Films aus metallischen Mikro- oder Nanopartikeln das Anbringen von metallischen Streifen an dem wärmeleitfähigen und elektrisch isolierenden Polymerfilm über der ersten Paste oder dem ersten trockenen Film aus metallischen Mikro- oder Nanopartikeln beinhaltet.

26. Verfahren zur Herstellung einer Anordnung nach Anspruch 18 oder 25, **dadurch gekennzeichnet, dass** es das Übertragen eines Verbindungsrahmens, der das Zwischenelement mit hoher elektrischer Leitfähigkeit umfasst, auf die Oberfläche der ersten Paste oder des ersten trockenen Films aus metallischen Mikro- oder Nanopartikeln beinhaltet, so dass das Zwischenelement mit hoher Wärmeleitfähigkeit eingeführt werden kann.

27. Verfahren zur Herstellung einer Anordnung nach einem der Ansprüche 18 bis 26, **dadurch gekennzeichnet, dass** es einen Schritt des Trocknens der ersten Paste oder der ersten Paste und der zweiten Paste vor dem Sinterungsvorgang beinhaltet.

28. Herstellungsverfahren nach einem der Ansprüche 18 bis 22, das die Erzeugung von metallischen Streifen beinhaltet, die wenigstens teilweise von einer gesinterten Dichtung gebildet werden, wobei das zum Übertragen der Wärme fähige Element mit der diskontinuierlichen gesinterten Dichtung mittels einer anderen gesinterten Dichtung verbunden ist.

## Claims

1. Assembly comprising:
- at least one element that is capable of transmitting heat (E);
- at least one electrically insulating substrate comprising at least one film (I_{P}) of a polymer that is a good thermal conductor and electrical insulator;
- at least one sintered metal joint (J1) that is in contact with said polymer film;
- a main radiator;
said main radiator being in direct contact, or in contact via a sintered joint, with said substrate.

2. Assembly according to claim 1, **characterized in that** the element that is capable of transmitting heat is a semiconductor component.

3. Assembly according to claim 2, **characterized in that** the element that is capable of transmitting heat is a silicon chip.

4. Assembly according to claim 1, **characterized in that** the element that is capable of transmitting heat is a thick metal structure whose thickness may typically be greater than about several tens of microns.

5. Assembly according to one of claims 1 to 4, **characterized in that** said sintered joint is discontinuous.

6. Assembly according to claim 5, comprising metal tracks that are at least partly formed by said sintered joint, the element that is capable of transmitting heat being connected to said discontinuous sintered joint via another sintered joint.

7. Assembly according to one of claims 1 to 5, **characterized in that** it comprises an intermediate element with high thermal conductivity (M), which may be metal, in contact with said joint, allowing a lateral distribution of the thermal flux that may be generated, in a plane that is parallel to the plane of said substrate.

8. Assembly according to claim 7, **characterized in that** the intermediate element with high thermal conductivity is inserted between a first joint (J1) and a second joint (J2), said second joint being in contact with said element that is capable of giving off heat.

9. Assembly according to claim 7, **characterized in that** said intermediate element comprises a set of metal tracks.

10. Assembly according to claim 7, **characterized in that** said intermediate element is an element belonging to a lead frame.

11. Assembly according to one of claims 1 to 10, **characterized in that** the first and/or second joints are metal joints that may be made of silver.

12. Assembly according to one of claims 1 to 11, **characterized in that** the thermally conductive and electrically insulating polymer is a polyimide or a polyamide or a polyamide-imide.

13. Assembly according to one of claims 1 to 12, **characterized in that** the thermally conductive and electrically insulating polymer is filled with particles that may be dielectric particles (made of alumina or boron nitride) or metal particles.

14. Assembly according to one of claims 1 to 13, **characterized in that** it comprises at least one thermally conductive and electrically insulating polymer film on the surface of said radiator or on the surface of said sintered joint.

15. Assembly according to one of claims 1 to 14, **characterized in that** the element that is capable of transmitting heat is a thick metal structure, the radiator being a thick metal structure, said metal structures potentially having thicknesses that are typically greater than about several tens of microns.

16. Assembly according to claim 15, **characterized in that** it comprises a stack comprising:
- at least a first thick metal structure;
- at least a first sintered joint;
- at least one polymer film;
- at least a second sintered joint;
- at least a second thick metal structure.

17. Assembly according to one of claims 1 to 16, **characterized in that** the radiator is a thick structure that may be made of copper or aluminium or AlSiC, the thickness of said thick structure typically potentially being greater than about 500 µm.

18. Method for manufacturing an assembly comprising:
- an element that is capable of transmitting heat;
- an electrically insulating substrate comprising at least one film of a polymer that is a good thermal conductor and electrical insulator;
- at least one main radiator;
- said main radiator being in direct contact, or in contact via a sintered joint, with said substrate,
said method comprising the production of a sintered metal joint in contact with said film of a polymer that is a good thermal conductor and electrical insulator.

19. Manufacturing method according to claim 18, comprising the production of said sintered metal joint between a thermally conductive and electrically insulating dry polymer film and said radiator.

20. Fabrication method according to claim 18, comprising the deposition of a thermally conductive and electrically insulating polymer resin on the surface of said radiator, followed by a step of drying said resin.

21. Manufacturing method according to one of claims 18 to 20, comprising the following steps:
- the deposition of at least a first paste or a first dry film of metal micro- or nanoparticles, intended to form a metal joint on the surface of said film of a polymer that is a good thermal conductor and electrical insulator;
- the deposition of said element that is capable of transmitting heat on top of said first paste or said first dry film of metal micro- or nanoparticles;
- a sintering operation so as to form a first sintered joint making the connection between said element that is capable of transmitting heat and said substrate.

22. Method for manufacturing an assembly according to claim 21, **characterized in that** the deposition of the first paste is carried out via screen printing.

23. Method for manufacturing an assembly according to one of claims 20 to 22, **characterized in that** it comprises:
- the introduction of an intermediate element with high thermal conductivity onto the surface of said first paste or said first film;
- the production of a second joint between said intermediate element and said element that is capable of giving off heat.

24. Method for manufacturing an assembly according to claim 23, **characterized in that** it comprises:
- the deposition of a second paste or a second dry film of metal micro- or nanoparticles on the surface of said intermediate element, intended to form a second joint;
- the deposition of said element that is capable of giving off heat on the surface of said second paste or said dry film;
- one or more sintering operation(s) so as to form a first sintered joint and a second sintered joint making the connection between said element that is capable of giving off heat and said substrate.

25. Method for manufacturing an assembly according to one of claims 18 or 24, **characterized in that** the introduction of an intermediate element with high thermal conductivity to the surface of said first paste or said first dry film of metal micro- or nanoparticles comprises the attachment of metal tracks to said thermally conductive and electrically insulating polymer film, on top of said first paste or said first dry film of metal micro- or nanoparticles.

26. Method for manufacturing an assembly according to one of claims 18 or 25, **characterized in that** it comprises the carryover of a lead frame comprising said intermediate element with high thermal conductivity on the surface of said first paste or said first dry film of metal micro- or nanoparticles allowing the introduction of said intermediate element with high thermal conductivity.

27. Method for manufacturing an assembly according to one of claims 18 to 26, **characterized in that** it comprises a step of drying said first paste or said first paste and said second paste before the sintering operation.

28. Manufacturing method according to one of claims 18 to 22, comprising the production of metal tracks that are at least partly formed by a sintered joint, the element that is capable of transmitting heat being connected to said discontinuous sintered joint via another sintered joint.
